# EUROPEAN PATENT SPECIFICATION

(11) **EP 3 868 920 B1**
(45) Date of publication and mention of the grant of the patent: **28.02.2024**
(21) Application number: 19872284.5
(22) Date of filing: 19.09.2019
(51) Int. Cl.: C23C 16/455, C23C 16/458, C23C 16/54, B65H 20/24, B65H 23/04

(54) **FILM FORMATION APPARATUS**
FILMERZEUGUNGSVORRICHTUNG
APPAREIL DE FORMATION DE FILM

(30) Priority: 18.10.2018 JP 2018196891
(43) Date of publication of application: 25.08.2021
(73) Proprietor: Creative Coatings Co., Ltd., Tokyo, 113-0023 (JP)
(72) Inventor: SATO, Eiji, Nagaoka-shi, Niigata 940-1164 (JP); SAKAMOTO, Hitoshi, Nagaoka-shi, Niigata 940-1164 (JP)
(74) Representative: Wunderlich & Heim Patentanwälte Partnerschaftsgesellschaft mbB
(86) International application number: PCT/JP2019/036700
(87) International publication number: WO 2020/080030

(56) References cited:
- JP-A- H06 349 745
- JP-A- H08 209 329
- JP-A- H10 298 764
- JP-A- 2009 209 381
- JP-A- 2012 184 492
- JP-A- 2014 118 607
- US-A1- 2013 344 257

## Description

### TECHNICAL FIELD

The present invention relates to a film deposition apparatus that introduces gas into a chamber and deposits a film on a long film that is conveyed in the chamber in a roll-to-roll manner.

### BACKGROUND ART

A film deposition apparatus performs sheet processing or batch processing in most cases; however, both of them cause an increase in complexity of a device for handling an object to be treated. Therefore, a long film that is an object to be treated is supplied in a roll-to-roll manner so as to perform continuous treatment, thereby improving throughput.

Patent Document 1 discloses a film deposition apparatus that deposits a film on a long film that is conveyed in a vacuum chamber in a roll-to-roll manner. In this film deposition apparatus, four film deposition means, each of which deposits a metal film on one side of a long film by a metalizing method using a dry plating method, are disposed along a conveying path for the long film. JP 2014 118 607 A discloses a comparable arrangement.

### RELATED-ART DOCUMENT

### PATENT DOCUMENT

Patent Document 1: JP-A-2018-2386 A further prior art document US 2013/0344257 A1 discloses the features of the preamble of claim 1. Here, application of a gas into a process chamber by means of a nozzle entering the process chamber perpendicularly with respect to the axis of a roller carrying a long film is disclosed.

### SUMMARY OF THE INVENTION

### TECHNICAL PROBLEM

A film deposition apparatus that deposits a film on a long film that is conveyed in a roll-to-roll manner has been conventionally limited to an apparatus in which film deposition is performed only on part of all conveyance paths of a long film as described in Patent Document 1.

It is an object of some aspects of the invention to provide a film deposition apparatus capable of smoothly conveying a long film in a roll-to-roll manner even when the principle of film deposition on a long film supplied in a roll-to-roll manner is the principle of film deposition not limited to a part within a chamber.

### SOLUTION TO PROBLEM

(1) In accordance with one of some embodiments, there is provided a film deposition apparatus, comprising:
   the features of claim 1.
   Preferred embodiments are defined by the dependent claims.

According to the one aspect of the invention (1), the long film conveyed by the film conveyer in a roll-to-roll manner is brought into contact with a film deposition gas in the chamber so as to have a film deposited thereon. In this case, the film conveyer disposed in the chamber includes the rotatable roller, and a region of the roller, the region being not covered by the long film, is brought into contact with the film deposition gas. However, in one aspect of the invention, the region of the roller, the region being not covered by the long film, is sprayed with an inert gas through a nozzle pipe. Owing to the jetting pressure of this inert gas, the film deposition gas does not come into contact with the roller. This prevents a failure of conveyance, stop of conveyance, or pollution of the long film all of which can be caused by film deposition on the roller.

(2) In the one aspect of the invention (1), the film conveyer may further include: a bearing part that rotatably supports a shaft of the roller; and a heater that heats the bearing part up to a temperature at which the film deposition gas does not adhere to the shaft. By doing so, the function and effect of another aspect of the invention (4) described later can be exerted.

(3) In the one aspect of the invention (1) or (2), the film conveyer may further include:
a rotatable tension detection roller in which the long film comes into contact with part of a peripheral surface of the tension detection roller;
a tension sensor detecting tension based on external force acting on the tension detection roller; and
a case including a slit that exposes the part of the peripheral surface of the tension detection roller, and the case surrounding both the tension sensor the tension detection roller except the part of the peripheral surface;
wherein,
an inert gas is introduced into the case at a pressure higher than a pressure in the chamber. In this situation, the inert gas is introduced into the case at a pressure higher than a pressure in the chamber. By doing so, the function and effect of yet another aspect of the invention (5) described later can be exerted.

(4) In accordance with one of some embodiments, there is provided a film deposition apparatus, comprising:
a chamber in which a target is provided and a film deposition gas for forming a film on the target is introduced thereinto and exhausted therefrom; and
a film conveyer disposed in the chamber and conveying in a roll-to-roll manner a long film that is the object to be treated;
wherein,
the film conveyer includes:
   a rotatable roller in which the long film comes into contact with part of a peripheral surface of the roller;
   a bearing part rotatably supporting a shaft of the roller; and
   a heater that heats the bearing part up to a temperature at which the film deposition gas does not adhere to the shaft.

According to the another aspect of the invention (4), the long film conveyed by the film conveyer in a roll-to-roll manner is brought into contact with the film deposition gas in the chamber so as to have a film deposited thereon. In this case, the film conveyer disposed in the chamber includes the bearing part that rotatably supports the shaft of the roller, and a supported part of the roller shaft may be brought into contact with the film deposition gas, thereby having a film deposited thereon. However, in the another aspect of the invention, the bearing part is heated by a heater and thereby the temperature of the shaft can be raised, through the bearing part, up to a temperature at which the film deposition gas does not adhere to the shaft. This prevents a failure of conveyance and stop of conveyance due to a failure of bearing all of which can be caused by film deposition on the roller shaft.

(5) In accordance with one of some embodiments, there is provided a film deposition apparatus, comprising:
a chamber in which a target is provided and a film deposition gas for forming a film on the target is introduced thereinto and exhausted therefrom;
a film conveyer disposed in the chamber and conveying in a roll-to-roll manner a long film that is the object to be treated;
wherein,
the film conveyer includes:
   a rotatable tension detection roller in which the long film comes into contact with part of a peripheral surface of the tension detection roller;
   a tension sensor detecting tension of the long film based on external force acting on the tension detection roller; and
   a case including a slit that exposes the part of the peripheral surface of the tension detection roller, and the case surrounding both the tension sensor and the tension detection roller except the part of the peripheral surface;
   wherein,
   an inert gas is introduced into the case at a pressure higher than a pressure in the chamber.

According to the yet another aspect of the invention (5), the long film conveyed by the film conveyer in a roll-to-roll manner is brought into contact with the film deposition gas in the chamber so as to have a film deposited thereon. In this case, the film conveyer disposed in the chamber includes: a rotatable tension detection roller in which the part of the peripheral surface of the tension detection roller comes into contact with the long film; and a tension sensor. A region of the tension detection roller, the region being not covered by the long film, and the tension sensor may be brought into contact with the film deposition gas. However, in the yet another aspect of the invention, into a case that surrounds both the tension sensor and the tension detection roller except the part of the peripheral surface, the part being in contact with the long film, an inert gas is introduced at a pressure higher than a pressure in the chamber. As a result, a flow of an inert gas from inside the case into the chamber occurs and the film deposition gas does not enter the case. This prevents a detection failure and an erroneous detection both of which can be caused by film deposition on the tension detection roller and the tension sensor, thereby ensuring a smooth supply of the long film.

### BRIEF DESCRIPTION OF THE DRAWINGS

FIG. 1 is a schematic cross-sectional view of a film deposition apparatus according to one embodiment of the invention.
FIG. 2 is a front view that illustrates a roller and a nozzle pipe that are disposed in a film conveyer.
FIG. 3 is a plan view of the nozzle pipe.
FIG. 4 is a view that illustrates the arrangement of the nozzle pipe illustrated in FIG. 3.
FIG. 5 is a cross-sectional view that illustrates a bearing part and a heater that are disposed in the film conveyer.
FIG. 6A is a plan view that illustrates a tension detection roller and a case surrounding the tension detection roller, and FIG. 6B is a cross-sectional view that illustrates the tension detection roller and the case.

### DESCRIPTION OF EMBODIMENTS

Hereinafter, a preferred embodiment of the invention will be described in detail. The embodiment described below does not limit unduly the scope of the claimed invention and all configurations described in the embodiment are not necessarily indispensable as means for solving the problem of the invention.

### 1. Overview of film deposition apparatus

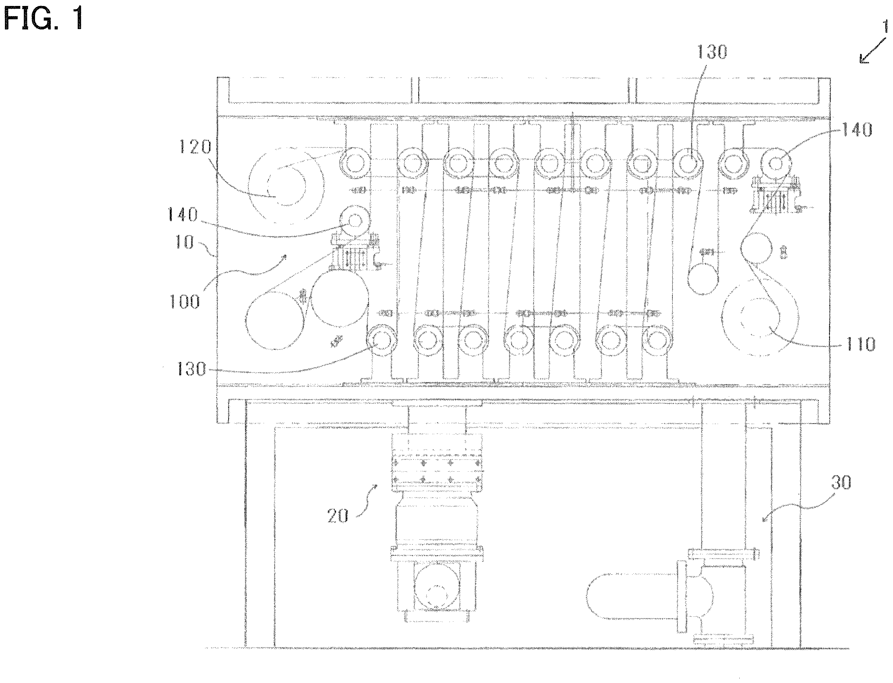

In FIG. 1, a film deposition apparatus 1 includes a chamber 10. The chamber 10 is, for example, a vacuum chamber; and an exhaust part 20 and a gas introduction part 30 are connected thereto. The exhaust part 20 evacuates the vacuum chamber 10 or exhausts an introduced gas. The gas introduction part 30 introduces one or a plurality of kinds of gases into the vacuum chamber 10. The plurality of kinds of gases can be simultaneously and/or selectively introduced. In addition, when, for example, the film deposition apparatus 1 is a plasma CVD apparatus, gas that has been turned into plasma outside the chamber 10 is introduced into the chamber 10 through the gas introduction part 30.

In the chamber 10, a film conveyer 100 that conveys a long film F that is an object to be treated is disposed. The film conveyer 100 conveys the long film F in a roll-to-roll manner. For this, the film conveyer 100 includes: an outfeed roller 110 that outfeeds the long film F that has been wound in a roll shape; and a winding roller 120 that winds up, into a roll shape, the long film F on which a film has been deposited. Between the outfeed roller 110 and the winding roller 120, a plurality of, for example, 19 rollers 130 having the same size and/or a different size and at least one, for example, two tension detection rollers 140 are disposed. Part of these rollers 110, 120, and 130 serves as a driving roller and the others serve as driven rollers. The film conveyer 100 intermittently conveys or continuously conveys the long film F according to a film deposition type.

The long film F is, during conveyance or stop, brought into contact with a deposition gas that is introduced into the chamber 10; and thereby has a film deposited thereon according to a film deposition principle. More specifically, this film deposition apparatus can deposit a film on any film deposition object at any position within the chamber 10, by contact with a film deposition gas that is introduced into the chamber 10. This type of film deposition principle may include a CVD in which a film is deposited by a vapor phase growth method and an ALD in which a film is deposited in an atomic layer unit. In a case of plasma CVD or the like that uses gas activated by using a plasma, an ultraviolet ray or the like as an energy source, the invention can be applied not only to a situation in which gas is locally activated within the chamber 10 but also to a situation in which gas activated outside the chamber 10 is introduced.

### 2. Prevention of film deposition on roller

The roller 130 illustrated in FIG. 1 is a rotatable roller in which a part of the peripheral surface of the roller comes into contact with the long film F. More specifically, when the roller 130 is drivingly or drivenly rotated, each partial peripheral surface of the roller 130, the each partial peripheral surface being not in contact with the long film F, is brought into contact with a film deposition gas one after another. Accordingly, a film may be deposited on the whole peripheral surface of the roller 130.

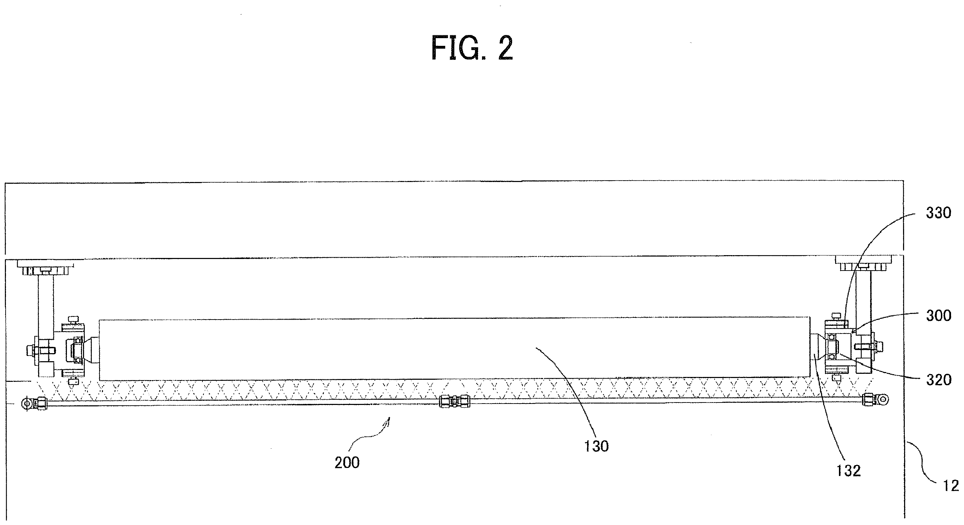

In order to prevent film deposition on the roller 130, a nozzle pipe 200 illustrated in FIG. 2 is disposed in parallel with a longitudinal axis of the roller 130 and at a position that faces a partial peripheral surface not covered by the long film F. The nozzle pipe 200 has jetting ports arranged along a longitudinal axis of the nozzle pipe 200. From the jetting ports of the nozzle pipe 200, an inert gas such as Ar or N₂ is jetted. A region of the roller 130, the region being not covered by the long film F, is sprayed with the inert gas through the nozzle pipe 200. Owing to the jetting pressure of this inert gas, the film deposition gas does not come into contact with the roller 130. This prevents a failure of conveyance, stop of conveyance, or contamination of the long film all of which can be caused by film deposition on the roller 130. On the other hand, since the inert gas does not affect film deposition using the film deposition gas on the long film F, film deposition on the long film F is not inhibited.

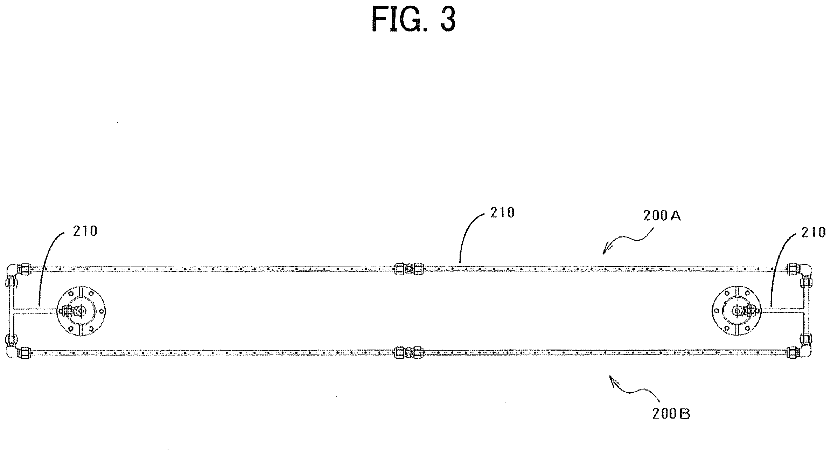

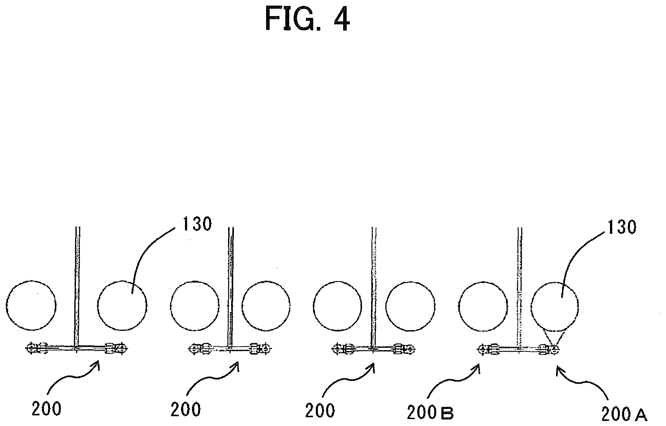

FIG. 3 is a plan view of the nozzle pipe 200. The nozzle pipe 200 illustrated in FIG. 3 prevents film deposition on two rollers 130 that are adjacent to each other in the chamber 10, as illustrated in FIG. 4. For this, the nozzle pipe 200 is, for example, disposed in a loop shape and jetting ports 210 are arranged on two parallel longitudinal axes 200A and 200B. In an example of FIG. 3, a gas supply pipe 220, 220 is coupled to both end parts in a longitudinal direction of the nozzle pipe 200, and the nozzle pipe 200 is supplied with an inert gas from both ends in the longitudinal direction. Thus, from the jetting ports 210 on the longitudinal axis 200A of the nozzle pipe 200 and the jetting ports 210 on the longitudinal axis 200B, an inert gas can be sprayed onto two rollers 130 (see FIG.4). The nozzle pipe 200 may have one longitudinal axis that faces one roller 130. Besides, it may have three or more longitudinal axes and spray an inert gas onto three or more rollers 130. When the nozzle pipe 200 is formed in a loop shape, interference with the long film F can be prevented by having the long film F conveyed so as to pass inside and outside the loop.

### 3. Prevention of film deposition on roller shaft

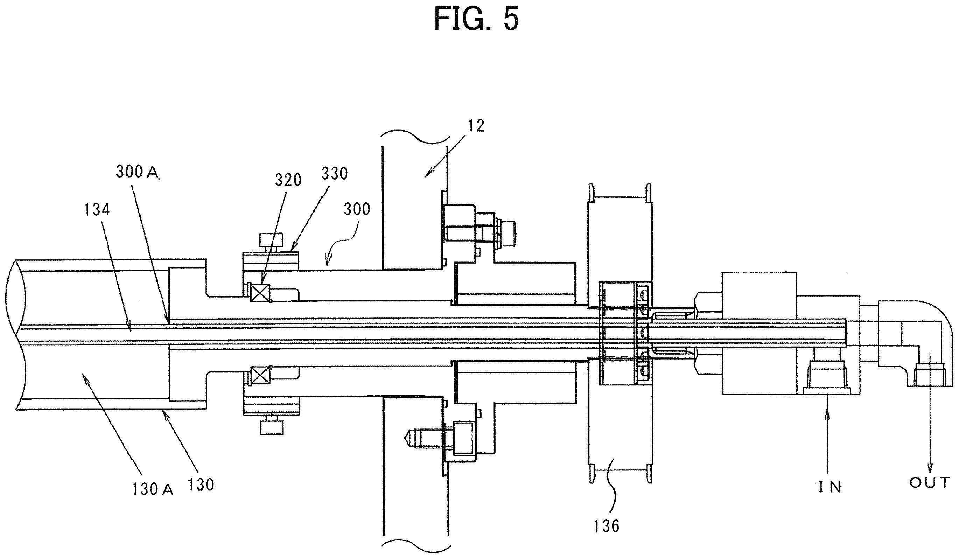

The roller 130 illustrated in FIG. 1 includes a bearing part 300 by which a shaft 132 of the roller 130 is rotatably supported, as illustrated in FIG. 5. The bearing part 300 includes a bearing body 310 that protrudes inside and outside of a chamber wall 12 of the chamber 10. The bearing body 310 is airtightly fixed to the chamber wall 12. At a tip end of the bearing body 310 that protrudes inside the chamber 10, a bearing 320 supporting the shaft 132 is disposed.

Part of the shaft 132 of the roller 130, the part being supported by the bearing 320, is brought into contact with a film deposition gas, thereby causing film deposition thereon. In order to prevent this film deposition, a heater, for example, a band heater 330, is arranged, for example, around where the bearing 320 is disposed, as illustrated in FIG. 5. The temperatures of the bearing part 300 and the shaft 132 are raised by the heater 330, so that a temperature range that does not allow the film deposition gas to be adhered to the shaft 132 can be kept. This prevents a failure of conveyance and stop of conveyance due to a failure of bearing that can be caused by film deposition on the shaft 132 of the roller 130.

Here, the temperature range set by the heater 330, the temperature range not allowing a film deposition gas to be adhered to the shaft 132, differs according to a film deposition type. For example, for Tris (Timethylamino) Silane (TDMAS: HSi[N(CH₃)₂]₃), 50 to 150°C and for Trimethyl Aluminum (TMA: Al(CH₃)₃), 80 to 200°C.

As in FIG. 5, a hollow part 130A is arranged in the roller 130 and a hollow part 132A is arranged in the shaft 132; and both the hollow parts 130A and 132A communicate with each other. In both the hollow parts 130A and 132A, an introduction pipe 134 for a coolant, for example, cooling water is disposed. Cooling water supplied from the introduction pipe 134 is introduced into the hollow part 130A of the roller 130 and cools the roller 130. In order to drain water from the hollow part 130A of the roller 130, the hollow part 132A formed in the shaft 132 is used as a cooling water lead-out path. Here, by cooling the roller 130, a surface of the film F, the surface coming into contact with the roller 130, can be kept at a low temperature while the bearing part 300 is heated by the heater 330. Note that in FIG. 5, a pulley 136 is arranged on the shaft 132 that has been taken outside the chamber wall 12. By belt-driving this pulley 136, the roller 130 is allowed to function as a driving roller, and in addition, dust during driving does not enter the chamber 10.

When the roller 130 is a driven roller, the pulley 136 is unnecessary. In FIG. 2, the roller 130 that is a driven roller is illustrated. In this case, the bearing part 300 is supported hanging down in the chamber 10. Also around the bearing 320 of this bearing part 300, a heater, for example, the band heater 330 is provided.

### 4. Prevention of film deposition on tension detection roller and tension sensor

Each of the tension detection rollers 140 illustrated in FIG. 1 is a rotatable roller in which part of the peripheral surface of the each roller 140 comes into contact with the long film F. More specifically, when the tension detection roller 140 is drivenly rotated, each partial peripheral surface of the tension detection roller 140, the each partial peripheral surface being not in contact with the long film F, is brought into contact with a film deposition gas one after another. As a result, a film may be deposited on the whole peripheral surface of the tension detection roller 140.

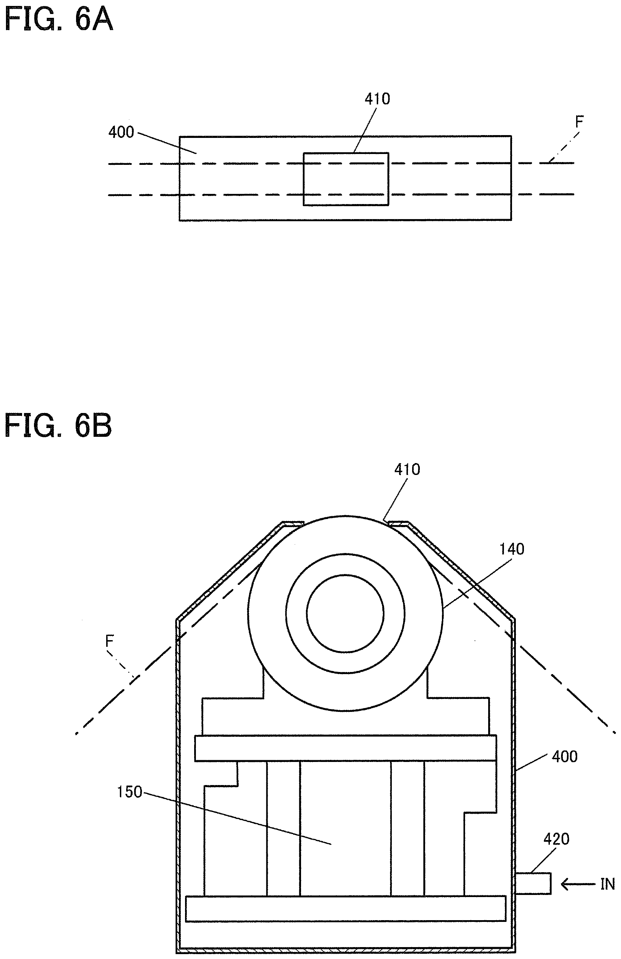

Therefore, a case 400 illustrated in FIG. 6A and FIG. 6B is arranged. The case 400 includes a slit 410 that allows part of a peripheral surface of the tension detection roller 140 to be exposed; and the case 400 surrounds the tension detection roller 140 except the part of the peripheral surface. In the case 400, a tension sensor 150 that detects tension based on external force acting on the tension detection roller 140 is also disposed. In addition, an inert gas such as Ar or N₂ is introduced into the case 400 at a pressure higher than a pressure in the chamber 10, through a gas supply pipe 420 coupled to the case 400.

As a result, a flow of an inert gas from inside the case 400 into the chamber 10 occurs and the film deposition gas does not enter the case 400. This prevents a failure of detection and erroneous detection that can be caused by film deposition on the tension detection roller 140 or the tension sensor 150, thereby ensuring a smooth supply of the long film F.

Although the embodiment has been described in detail above, those skilled in the art will readily appreciate that many modifications are possible without materially departing from the novel teachings and advantages of the invention. Accordingly, all such modifications are intended to be included within scope of this invention. For example, in the description or drawings, a term described together with a different term having wider meaning or the same meaning at least once can be replaced with the different term at any portion of the description or drawings. In addition, all combinations of the embodiment and the modifications are also included within the scope of the invention.

### REFERENCE SIGN LIST

- 1: film deposition apparatus
- 10: chamber
- 20: exhaust part
- 30: gas introduction part
- 100: film conveyer
- 110: outfeed roller
- 120: winding roller
- 130: roller
- 130A: hollow part
- 132: shaft
- 132A: hollow part (coolant lead-out path)
- 134: coolant introduction pipe
- 136: pulley
- 140: tension detection roller
- 150: tension sensor
- 200: nozzle pipe
- 200A, 200B: parallel longitudinal axes
- 210: jetting port
- 220: gas supply pipe
- 300: bearing part
- 310: bearing body
- 320: bearing
- 330: heater
- 400: case
- 410: slit
- 420: gas supply pipe

## Claims

1. A film deposition apparatus, comprising:
a chamber (10) in which a target is provided and a film deposition gas for forming a film on the target is introduced thereinto and exhausted therefrom; and
a film conveyer (100) disposed in the chamber (10) and conveying in a roll-to-roll manner a long film (F) that is the object;
wherein,
the film conveyer (100) includes:
at least one rotatable roller (130) in which the long film (F) comes into contact with part of a peripheral surface of the roller (130); and
a nozzle pipe (200) that sprays an inert gas onto the roller (130) at a region being not covered by the long film (F)
**characterized in that**
the rotatable roller (130) has a first longitudinal axis,
the nozzle pipe (200) has a second longitudinal axis, and
the nozzle pipe (200) is disposed so that the second longitudinal axis set in parallel with the first longitudinal axis of the rotatable roller (130), and has jetting ports arranged along the second longitudinal axis of the nozzle pipe (200).

2. The film deposition apparatus according to claim 1, wherein
the film conveyer (100) further includes:
a bearing part (300) rotatably supporting a shaft (132) of the roller (130); and
a heater (330) that heats the bearing part (300) up to a temperature at which the film deposition gas does not adhere to the shaft (132).

3. The film deposition apparatus according to claim 1 or 2, wherein
the film conveyer (100) further includes:
a rotatable tension detection roller (140) in which the long film (F) comes into contact with part of a peripheral surface of the tension detection roller (140);
a tension sensor (150) detecting tension based on external force acting on the tension detection roller (140); and
a case (400) including a slit (410) that exposes the part of the peripheral surface of the tension detection roller (140), and the case (400) surrounding both the tension sensor (150) and the tension detection roller (140) except the part of the peripheral surface; wherein,
an inert gas is introduced into the case (400) at a pressure higher than a pressure in the chamber (10).

4. The film deposition apparatus according to claim 1, wherein
the at least one rotatable roller (130) includes two rotatable rollers (130) each having the first longitudinal axis,
the nozzle pipe (200) is disposed in a loop shape that has each second longitudinal axis (200A, 200B) respectively parallel with each first longitudinal axis of the rotatable roller (130), and
the jetting ports (210) are arranged along each second longitudinal axis (200A, 200B) of the nozzle pipe (200).

5. The film deposition apparatus according to any of claims 1 to 4, wherein
the parallelly to the first longitudinal axis arranged nozzle pipe (200) with the jetting ports is disposed at a position that faces the partial peripheral surface of the at least one rotatable roller (130) which is not covered by the long film (F) .

## Patentansprüche

1. Filmablagerungsvorrichtung, welche aufweist:
eine Kammer (10), in welcher ein Ziel vorgesehen ist und wohin ein Filmablagerungsgas zum Bilden eines Films auf dem Ziel eingeleitet und von dort abgesaugt wird; und
eine Filmfördereinrichtung (100), die in der Kammer (10) angeordnet ist und in einer Walz-zu-Walz-Weise einen langen Film (F), der das Zielobjekt ist, befördert;
wobei,
die Filmfördereinrichtung (100) umfasst:
- mindestens eine drehbare Walze (130), in welcher der lange Film (F) in Berührung mit einem Teil einer Umfangsfläche der Walze (130) kommt; und
- ein Düsenrohr (200), das ein Inertgas auf die Walze (130) auf eine Region sprüht, die nicht von dem langen Film (F) bedeckt ist,
**dadurch gekennzeichnet, dass**
die drehbare Walze (130) eine erste Längsachse aufweist,
das Düsenrohr (200) eine zweite Längsachse aufweist, und
das Düsenrohr (200) so angeordnet ist, dass die zweite Längsachse parallel mit der ersten Längsachse der drehbaren Walze (130) gesetzt ist und Düsenöffnungen aufweist, die entlang der zweiten Längsachse des Düsenrohrs (200) angeordnet sind.

2. Filmablagerungsvorrichtung nach Anspruch 1, wobei die Filmfördereinrichtung (100) weiter umfasst:
ein Lagerteil (300), das eine Welle (132) der Walze (130) drehbar lagert; und
eine Heizung (330), die das Lagerteil (300) bis zu einer Temperatur erhitzt, bei welcher das Filmablagerungsgas nicht an der Welle (132) haftet.

3. Filmablagerungsvorrichtung nach Anspruch 1 oder 2, wobei
die Filmfördereinrichtung (100) weiter umfasst:
eine drehbare Spannungsdetektionswalze (140), in welcher der lange Film (F) in Kontakt mit einer Teilumfangsfläche der Spannungsdetektionswalze (140) kommt;
einen Spannungssensor (150), der Spannung aufgrund von einer auf die Spannungsdetektionswalze (140) wirkenden äußeren Kraft detektiert; und
ein Gehäuse (400), das einen Schlitz (410) enthält, der die Teilumfangsfläche der Spannungsdetektionswalze (140) freilegt und das Gehäuse (400) den Spannungssensor (150) und die Spannungsdetektionswalze (140) mit Ausnahme der Teilumfangsfläche umgibt; wobei
ein Inertgas in das Gehäuse (400) bei einem Druck größer als ein Druck in der Kammer (10) eingeleitet wird.

4. Filmablagerungsvorrichtung nach Anspruch 1, wobei die mindestens eine drehbare Walze (130) zwei drehbare Walzen (130) umfasst, die jeweils die erste Längsachse aufweisen,
das Düsenrohr (200) in einer Schleifenform angeordnet ist, bei der jede zweite Längsachse (200a, 200b) jeweils parallel mit jeder ersten Längsachse der drehbaren Walze (130) verläuft, und
die Düsenöffnungen (210) entlang jeder zweiten Längsachse (200a, 200b) des Düsenrohrs (200) angeordnet sind.

5. Filmablagerungsvorrichtung nach einem der Ansprüche 1 bis 4, wobei
das parallel zu der ersten Längsachse angeordnete Düsenrohr (200) mit den Düsenöffnungen an einer Stelle gegenüber der Teilumfangsfläche der mindestens einen drehbaren Walze (130) angeordnet ist, die nicht von dem langen Film (F) bedeckt ist.

## Revendications

1. Appareil de dépôt de film, comprenant :
une chambre (10) dans laquelle une cible est fournie et un gaz de dépôt de film pour former un film sur la cible est introduit dans celle-ci et évacué de celle-ci ; et
un transporteur de film (100) disposé dans la chambre (10) et transportant rouleau à rouleau un long film (F) qui est l'objet ;
dans lequel,
le transporteur de film (100) inclut :
au moins un rouleau rotatif (130) dans lequel le long film (F) entre en contact avec une partie d'une surface périphérique du rouleau (130) ; et
un tube injecteur (200) qui pulvérise un gaz inerte sur le rouleau (130) au niveau d'une région n'étant pas recouverte par le long film (F)
**caractérisé en ce que**
le rouleau rotatif (130) présente un premier axe longitudinal,
le tube injecteur (200) présente un second axe longitudinal, et
le tube injecteur (200) est disposé de sorte que le second axe longitudinal soit placé en parallèle du premier axe longitudinal du rouleau rotatif (130), et présente des orifices d'éjection agencés le long du second axe longitudinal du tube injecteur (200).

2. Appareil de dépôt de film selon la revendication 1, dans lequel
le transporteur de film (100) inclut en outre :
une partie de palier (300) supportant de manière rotative un arbre (132) du rouleau (130) ; et
un dispositif de chauffage (330) qui chauffe la partie de palier (300) jusqu'à une température à laquelle le gaz de dépôt de film n'adhère pas à l'arbre (132).

3. Appareil de dépôt de film selon la revendication 1 ou 2, dans lequel
le transporteur de film (100) inclut en outre :
un rouleau de détection de tension rotatif (140) dans lequel le long film (F) entre en contact avec une partie d'une surface périphérique du rouleau de détection de tension (140) ;
un capteur de tension (150) détectant une tension sur la base d'une force externe agissant sur le rouleau de détection de tension (140) ; et
un carter (400) incluant une fente (410) qui met à nu la partie de la surface périphérique du rouleau de détection de tension (140), et le carter (400) entourant à la fois le capteur de tension (150) et le rouleau de détection de tension (140) excepté la partie de la surface périphérique ; dans lequel,
un gaz inerte est introduit dans le carter (400) à une pression supérieure à une pression dans la chambre (10).

4. Appareil de dépôt de film selon la revendication 1, dans lequel
l'au moins un rouleau rotatif (130) inclut deux rouleaux rotatifs (130) présentant chacun le premier axe longitudinal,
le tube injecteur (200) est disposé en une forme de boucle qui présente chaque second axe longitudinal (200A, 200B) respectivement parallèle à chaque premier axe longitudinal du rouleau rotatif (130), et
les orifices d'éjection (210) sont agencés le long de chaque second axe longitudinal (200A, 200B) du tube injecteur (200).

5. Appareil de dépôt de film selon l'une quelconque des revendications 1 à 4, dans lequel
le tube injecteur (200), agencé parallèlement au premier axe longitudinal avec les orifices d'éjection, est disposé à une position qui fait face à la surface périphérique partielle de l'au moins un rouleau rotatif (130) qui n'est pas recouverte par le long film (F).
